# EUROPEAN PATENT APPLICATION

(11) **EP 4 513 373 A1**
(43) Date of publication of application: **26.02.2025**
(21) Application number: 24195602.8
(22) Date of filing: 21.08.2024
(51) Int. Cl.: G06F 30/392, G06F 30/398

(54) **DESIGN BLOCK VALIDATION WITHIN A SEMICONDUCTOR LAYOUT DESIGN**

(30) Priority: 23.08.2023 US 202318237107
(71) Applicant: Siemens Industry Software Inc., Plano, TX 75024 (US)
(72) Inventor: KHALAF, Sara, 11765 Cairo (EG); HEIBA, Mostafa, 11724 Alzaytoun, Cairo (EG); MUIRHEAD, Jonathan James, 97224 Portland, OR (US)
(74) Representative: Horn Kleimann Waitzhofer Schmid-Dreyer Patent- und Rechtsanwälte PartG mbB

(57) **Abstract**

A computing system implementing a physical verification tool can extract cells describing integrated circuitry from a semiconductor layout design, identify one or more of the extracted cells corresponds to candidate cells for validation based on sizes of the extracted cells relative to a size of a target design of integrated circuitry, and modify the semiconductor layout design to remove integrated circuitry not corresponding to the candidate cells. The physical verification tool also can generate a target layout design that includes copies of the target design of integrated circuitry at locations corresponding to the candidate cells in the semiconductor layout design, and perform a validation of the semiconductor layout design by determining at least one of the extracted cells corresponds to a modified version of the target design of integrated circuitry based on a comparison of the modified semiconductor layout design and the target layout design.

## Description

### TECHNICAL FIELD

This application is generally related to electronic design automation and, more specifically, to semiconductor layout design validation with modified circuit block identification.

### BACKGROUND

In a design flow for fabricating integrated circuits, a physical design of an integrated circuit can describe specific geometric elements, often referred to as a layout design. The geometric elements, which typically are polygons, define the shapes that will be created in various materials to manufacture the integrated circuit. Typically, a designer will select groups of geometric elements representing circuit device components, e.g., contacts, gates, etc., and place them in a design area. These groups of geometric elements may be custom designed, selected from a library of previously-created designs, sometimes called semiconductor intellectual property (IP), design IP, IP blocks, or the like, or some combination of both. Once the groups of geometric elements representing circuit device components have been placed, geometric elements representing connection lines then are then placed between these geometric elements according to the predetermined route. These lines will form the wiring used to interconnect the electronic devices.

Descriptions for physical designs of integrated circuits can be provided in many different formats, such as a Graphic Data System II (GDSII) format, an Open Access format, a Milkyway format, component-level netlist EDDM format, and Open Artwork System Interchange Standard (OASIS) format. These various industry formats can be used to define the geometrical information in layout designs employed to manufacture integrated circuits. Some of the formats, such as the GDSII format, can include a hierarchy of structures, each having layout elements, for example, polygons, paths, poly-lines, circles, textboxes, or the like. Once the layout design is finalized, a reticle or mask can be generated from the layout design, which can be used to manufacture the integrated circuits using a photolithographic process.

Since most layout designs for integrated circuits include one or more previously-created IP blocks, designers often perform a validation process-after placement of the IP block, routing of wiring into the layout design, and insertion of dummy fill structures into the layout designs-to determine whether the IP blocks remain unmodified in the layout designs and thus avoid having their performance degraded. Existing approaches to validate for IP blocks incorporated into layout designs for integrated circuits, such as a complex Design Rule Check (DRC) analysis, layout versus layout (LVL), and pattern matching, are often error-prone, time-consuming, and heavily dependent manual set-up or oversight. For example, performing a complex Design Rule Check (DRC) analysis for validation requires custom-written design rules for the particular IP block being validated, which involves significant manual effort. The LVL approach can compare portions of the layout design to compare to an IP block to perform the validation, but the approach is dependent on being able to identify the IP blocks in the portion of the layout by the assigned name and also dependent of the ability to identify a precise location of the portion of the layout design to compare, both of which are error-prone. The pattern matching approach can identify exact matches of an IP block in the layout design, but has difficulty identifying when the layout design includes a modified version of the IP block.

### SUMMARY

This application discloses a computing system implementing a physical verification tool to extract cells describing integrated circuitry from a semiconductor layout design, identify one or more of the extracted cells corresponds to candidate cells for validation based on sizes of the extracted cells relative to a size of a target design of integrated circuitry, such as an Intellectual Property (IP) design block, a standard design cell, or the like. The physical verification tool can modify the semiconductor layout design to remove integrated circuitry not corresponding to the candidate cells. The physical verification tool also can generate a target layout design that includes copies of the target design of integrated circuitry at locations corresponding to the candidate cells in the semiconductor layout design, and perform a validation of the semiconductor layout design by determining at least one of the extracted cells corresponds to a modified version of the target design of integrated circuitry based on a comparison of the modified semiconductor layout design and the target layout design. Embodiments of will be described below in greater detail.

### DESCRIPTION OF THE DRAWINGS

Figures 1 and 2 illustrate an example of a computer system of the type that may be used to implement various embodiments.
Figure 3 illustrates an example layout validation system with modified circuit block identification that may be implemented according to various embodiments.
Figure 4 illustrate an example of layout design generation for circuit block validation and identification of circuit block modification according to various examples.
Figures 5A-5D illustrate examples of identifiable circuit block modifications in a physical layout design according to various embodiments.
Figure 6 illustrates an example flowchart for circuit block validation and identification of circuit block modification that may be implemented according to various embodiments.

### DETAILED DESCRIPTION

### Illustrative Operating Environment

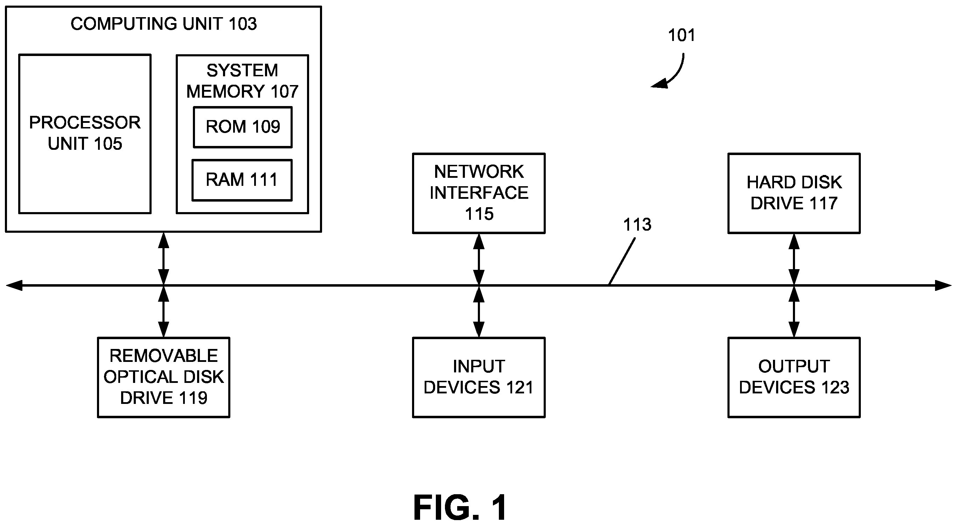

Various examples may be implemented through the execution of software instructions by a computing device 101, such as a programmable computer. Accordingly, Figure 1 shows an illustrative example of a computing device 101. As seen in this figure, the computing device 101 includes a computing unit 103 with a processor unit 105 and a system memory 107. The processor unit 105 may be any type of programmable electronic device for executing software instructions, but will conventionally be a microprocessor. The system memory 107 may include both a read-only memory (ROM) 109 and a random access memory (RAM) 111. As will be appreciated by those of ordinary skill in the art, both the read-only memory (ROM) 109 and the random access memory (RAM) 111 may store software instructions for execution by the processor unit 105.

The processor unit 105 and the system memory 107 are connected, either directly or indirectly, through a bus 113 or alternate communication structure, to one or more peripheral devices 115-123. For example, the processor unit 105 or the system memory 107 may be directly or indirectly connected to one or more additional memory storage devices, such as a hard disk drive 117, which can be magnetic and/or removable, a removable optical disk drive 119, and/or a flash memory card. The processor unit 105 and the system memory 107 also may be directly or indirectly connected to one or more input devices 121 and one or more output devices 123. The input devices 121 may include, for example, a keyboard, a pointing device (such as a mouse, touchpad, stylus, trackball, or joystick), a scanner, a camera, and a microphone. The output devices 123 may include, for example, a monitor display, a printer and speakers. With various examples of the computing device 101, one or more of the peripheral devices 115-123 may be internally housed with the computing unit 103. Alternately, one or more of the peripheral devices 115-123 may be external to the housing for the computing unit 103 and connected to the bus 113 through, for example, a Universal Serial Bus (USB) connection.

With some implementations, the computing unit 103 may be directly or indirectly connected to a network interface 115 for communicating with other devices making up a network. The network interface 115 can translate data and control signals from the computing unit 103 into network messages according to one or more communication protocols, such as the transmission control protocol (TCP) and the Internet protocol (IP). Also, the network interface 115 may employ any suitable connection agent (or combination of agents) for connecting to a network, including, for example, a wireless transceiver, a modem, or an Ethernet connection. Such network interfaces and protocols are well known in the art, and thus will not be discussed here in more detail.

It should be appreciated that the computing device 101 is illustrated as an example only, and it not intended to be limiting. Various embodiments may be implemented using one or more computing devices that include the components of the computing device 101 illustrated in Figure 1, which include only a subset of the components illustrated in Figure 1, or which include an alternate combination of components, including components that are not shown in Figure 1. For example, various embodiments may be implemented using a multiprocessor computer, a plurality of single and/or multiprocessor computers arranged into a network, or some combination of both.

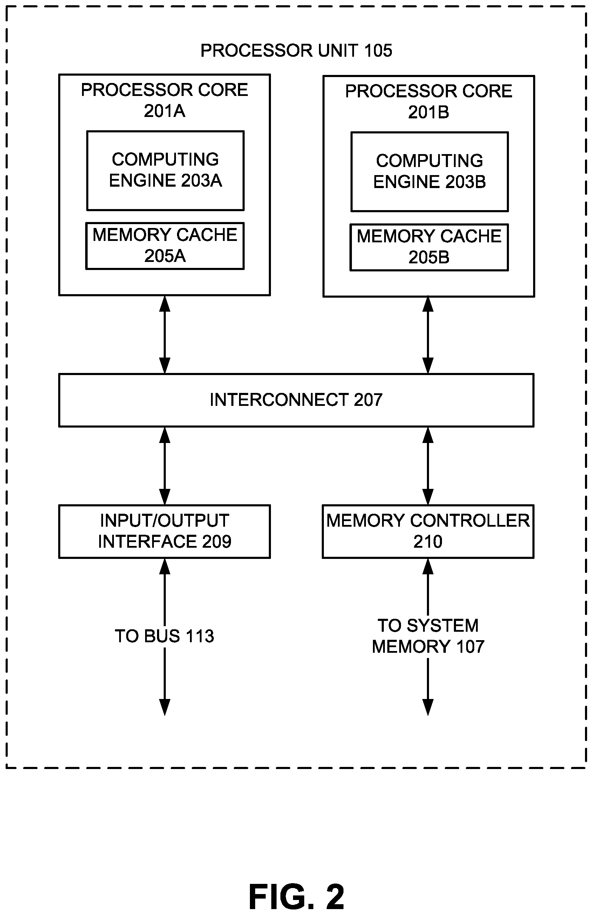

With some implementations, the processor unit 105 can have more than one processor core. Accordingly, Figure 2 illustrates an example of a multi-core processor unit 105 that may be employed with various embodiments. As seen in this figure, the processor unit 105 includes a plurality of processor cores 201A and 201B. Each processor core 201A and 201B includes a computing engine 203A and 203B, respectively, and a memory cache 205A and 205B, respectively. As known to those of ordinary skill in the art, a computing engine 203A and 203B can include logic devices for performing various computing functions, such as fetching software instructions and then performing the actions specified in the fetched instructions. These actions may include, for example, adding, subtracting, multiplying, and comparing numbers, performing logical operations such as AND, OR, NOR and XOR, and retrieving data. Each computing engine 203A and 203B may then use its corresponding memory cache 205A and 205B, respectively, to quickly store and retrieve data and/or instructions for execution.

Each processor core 201A and 201B is connected to an interconnect 207. The particular construction of the interconnect 207 may vary depending upon the architecture of the processor unit 105. With some processor cores 201A and 201B, such as the Cell microprocessor created by Sony Corporation, Toshiba Corporation and IBM Corporation, the interconnect 207 may be implemented as an interconnect bus. With other processor units 201A and 201B, however, such as the Opteron^{™} and Athlon^{™} dual-core processors available from Advanced Micro Devices of Sunnyvale, California, the interconnect 207 may be implemented as a system request interface device. In any case, the processor cores 201A and 201B communicate through the interconnect 207 with an input/output interface 209 and a memory controller 210. The input/output interface 209 provides a communication interface to the bus 113. Similarly, the memory controller 210 controls the exchange of information to the system memory 107. With some implementations, the processor unit 105 may include additional components, such as a high-level cache memory accessible shared by the processor cores 201A and 201B. It also should be appreciated that the description of the computer network illustrated in Figure 1 and Figure 2 is provided as an example only, and is not intended to suggest any limitation as to the scope of use or functionality of alternate embodiments.

### Semiconductor Layout Design Validation with Modified Circuit Block Identification

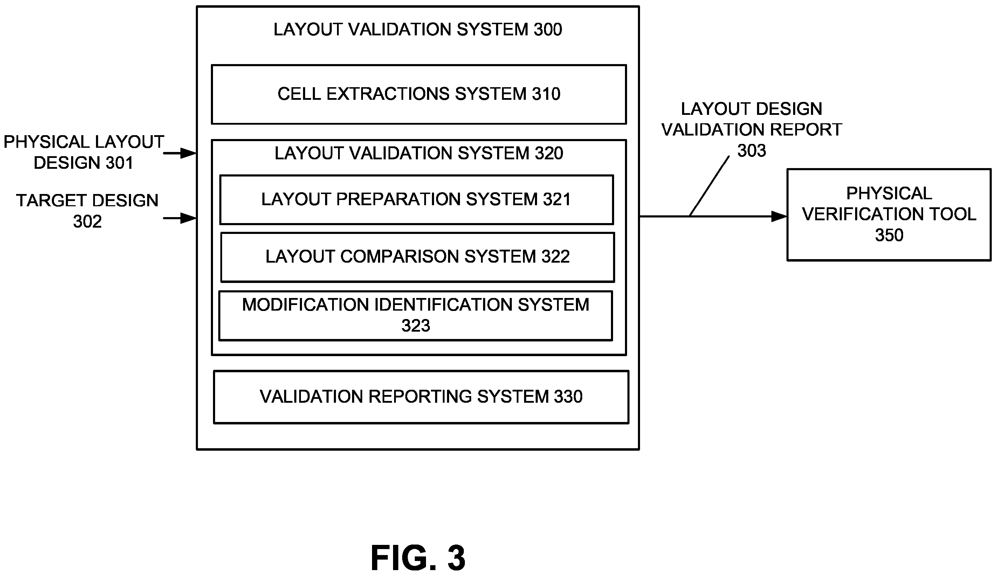

Figure 3 illustrates an example layout validation system 300 with modified circuit block identification that may be implemented according to various embodiments. Referring to Figure 3, the layout validation system 300, for example, implemented by the computing device 101 in Figure 1, can receive a physical layout design 301 that describes an integrated circuit as geometric information defining the shapes, such as polygon structures, capable of being created in various materials to manufacture the integrated circuit. The physical layout design 301 can be specified in a Graphic Data System II (GDSII) format, an Open Access format, a Milkyway format, an EDDM format, an Open Artwork System Interchange Standard (OASIS) format, or the like.

The layout validation system 300 also can receive at least one target design 302 that describes a block or cell of integrated circuitry as geometric information defining the shapes, such as polygon structures, capable of being created in various materials to manufacture the integrated circuit. The target design 302 can be a previously-created design block or design cell, for example, a standard cell included in a standard cell library, a design block or design cell of design Intellectual Property (IP), for example, acquired from a third party vendor, or the like. The target design 302 can be specified in a Graphic Data System II (GDSII) format, an Open Access format, a Milkyway format, an EDDM format, an Open Artwork System Interchange Standard (OASIS) format, or the like.

The layout validation system 300 can perform a validation process to determine whether the target design 302 was included within the physical layout design 301 and also to identify whether the physical layout design 301 includes a modified version of the target design 302. The layout validation system 300 can generate a layout design validation report 303 to identify one or more design cells or design blocks in the physical layout design 301 that correspond to the target design 302 or a modified version of the target design 302. In some embodiments, the layout design validation report 303 can identify a type of modification to the target design 302 included in the physical layout design 302. The layout validation system 300 can output the layout design validation report 303, for example, to a physical verification tool 350, which, in some embodiments, can utilize the identification of the target designs 302 and the modified version of the target designs 302 to modify the physical layout design 301, such as route wire lines, insert or remove dummy fill structures, or the like.

The layout validation system 300 can include a cell extraction system 310 to identify one or more design cells in the physical layout design 301 to validate against the target design 302. The cell extraction system 310 can determine a size of the target design 302, for example, a height and a width of the target design 302. In some embodiments, the cell extraction system 310 can query the target design 302 to ascertain a height and a width of the target design 302.

The cell extraction system 310 can analyze the physical layout design 301 to identify a plurality of design cells in the physical layout design 301, and then extract one or more of the identified design cells as having a size or dimensions that corresponds to the determined size of the target design 302. The cell extraction system 310 can deem the extracted design cells as candidate cells for validation against the target design 302. The cell extraction system 310 also can determine the locations of the candidate cells extracted from the physical layout design 301.

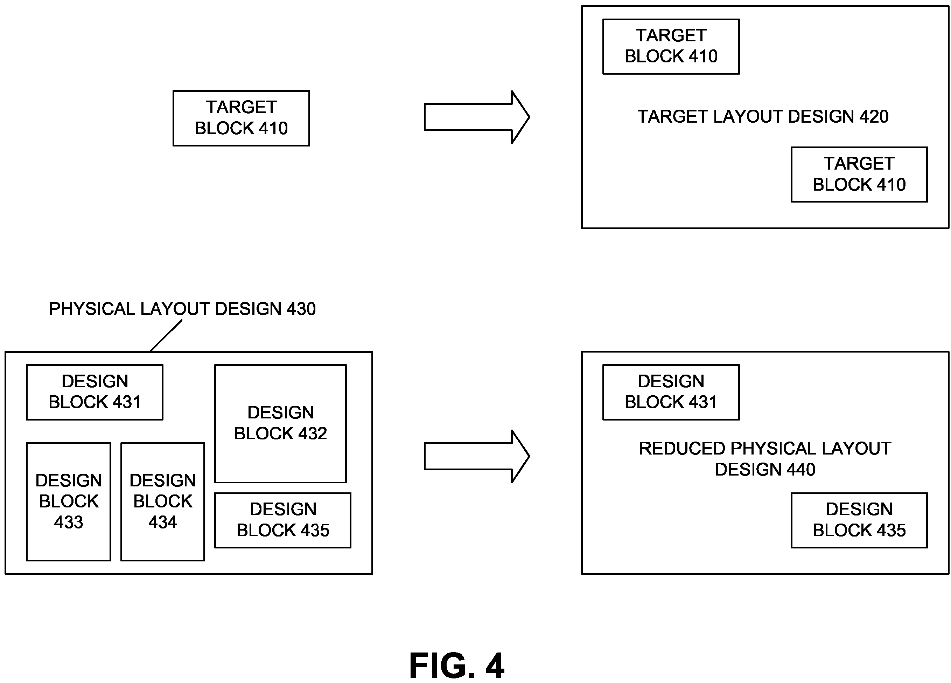

The layout validation system 300 can include a layout validation system 320 to perform a validation of the candidate cells extracted from the physical layout design 301 against the target design 302. The layout validation system 320 can include layout preparation system 321 to modify the physical layout design 301 to remove design cells not corresponding to the candidate cells. In some embodiments, the layout preparation system 321 can generate a layout design and insert the candidate cells into locations of the layout design that correspond to the locations of the candidate cells in the physical layout design 301. The layout preparation system 321 also can generate a target layout that includes copies of the target design 302 at locations corresponding to the locations of the candidate cells in the physical layout design 301. By generating two layout designs, a reduced physical layout design with candidate cells and the target layout design with copies of the target design 302 at the same relative locations in their respective layout design, the layout validation system 300 can perform a layout versus layout comparison to identify whether the candidate cells extracted from the physical layout design 301 correspond to the target design 302 or a modified version of the target design 302. Embodiments of layout preparation will be described below with reference to Figure 4.

Figure 4 illustrate an example of layout design generation for circuit block validation and identification of circuit block modification according to various examples. Referring to Figure 4, a target block 410 can correspond to a physical design of integrated circuitry, which may have been placed in a physical layout design 430 of a larger integrated circuit device. The physical layout design 430 can include multiple design blocks 431-435, which also correspond to physical designs of integrated circuitry.

The performance of the automated validation of the physical layout design 430, for example, by the layout preparation system 321 and layout comparison system 322 in Figure 3, can generate a pair of layout designs-a target layout design 420 and a reduced physical layout design 440-configured to be compared during the automated validation process. The generation of the layout designs can begin with a characterization of the target block 410, for example, determining the dimensions of the target block 410, such as a height and a width. Next, an extraction of one or more of the design blocks 431-435 from the physical layout design 430 can occur, for example, the size of the design blocks 431-435 can be compared against the dimensions of the target block 410 and those design block 431-435 having dimensions that correspond to the target block 410 can be extracted. In this example, the design blocks 431 and 435 have a size that matches the dimensions of the target block 410, which indicates that those design blocks 431 and 435 can be validated to determine whether they correspond to the target design block 410.

The automated validation process can generate the reduced physical layout design 440 by removing the design blocks 432-434 from the physical layout design 420, as those design blocks 432-434 did not have sizes that matches the dimensions of the target block 410. The automated validation process can generate the target layout design 420 by identifying locations of the design block 431 and 435 in the physical layout design 420 and inserting the target block 410 into the target layout design 420 at the identified locations of the design blocks 431 and 435 in the physical layout design 420. By generating a pair of layout designs with target blocks 410 and design block 431 and 435 in the same respective locations, the pair of layout designs can be compared to determine whether the design blocks 431 and 435 correspond to an unmodified version or a modified version of the target block 410. In some embodiments, rather than generating a reduced physical design layout 440, the automated validation process can copy the design block 431 and 435 into a new layout design, which can be utilized to compare the design blocks 431 and 435 to the target block 410. For example, the design blocks 431 and 435 can be located in the new layout design in the same respective locations as the target block 410 is located in the target layout design 420. In another example, the new layout design can be populated with the design blocks 431 and 435 and at least one target block 410 in a shifted relative location from the design blocks 431 and 435. The automated validation process can compare the target block 410 and the design blocks 431 and 435 in the new layout design with the shifted relative locations utilized to determine whether the design blocks 431 and 435 correspond to an unmodified version or a modified version of the target block 410.

Referring back to Figure 3, the layout validation system 320 can include a layout comparison system 322 to compare the target layout design with the reduced physical layout design to determine whether any of the candidate cells in the reduced physical layout design match the target design 302. When a candidate cell matches with the target design 302, the layout comparison system 322 can deem the candidate cell an unmodified version of the target design 302. In some embodiments, the layout comparison system 322 can perform the comparison using an exclusive OR (XOR) operation on different layers of the target layout design and the reduced physical layout design.

The layout comparison system 322, in some embodiments, can perform the comparison of the target layout design with the reduced physical layout design different modes, a cell-level mode and higher-level mode. In the cell-level mode, the layout comparison system 322 can compare the target layout design with the reduced physical layout design at the levels corresponding to the target design 302, while ignoring design features in higher levels of hierarchy within the reduced physical layout design. In the higher-level mode, the layout comparison system 322 can compare the target layout design with the reduced physical layout design at a top-level of the reduced physical layout design, allowing the comparison within the extent of the target design 302 and across the levels of the hierarchy in the reduced physical layout design.

In some embodiments, the layout validation system 320 can perform a comparison of the candidate cells directly with the target design 302, rather than in a layout versus layout process, for example, by generating checksums of the candidate cells and the target design 302, and then comparing the checksums to identify when a candidate cell matches with the target design 302. This direct comparison, in some embodiments, can be performed prior to the layout preparation with any matching candidate cells being excluded from the reduced physical layout design and copies of a corresponding target design 302 excluded form the target layout design at locations corresponding to the excluded candidate cells.

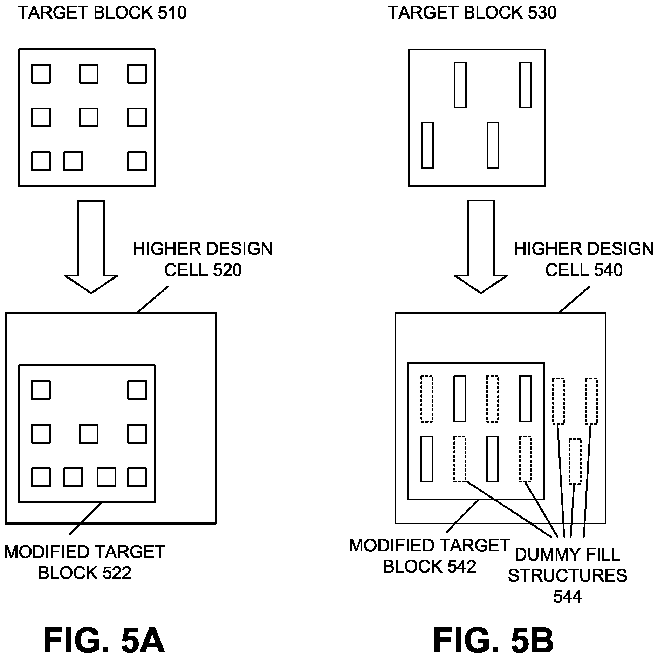

When the comparison of the target layout design with the reduced physical layout design by the layout comparison system 322 results in one or more of the candidate cells in the reduced physical layout design not matching the target design 302, the layout validation system 320 can include modification identification system 323 to determine whether any of those unmatched candidate cells correspond to a modified version of the target design 302. Examples of identifiable circuit block modifications will be described below with reference to Figures 5A-5D.

Figures 5A-5D illustrate examples of identifiable circuit block modifications in a physical layout design according to various embodiments. Referring to Figures 5A-5D, target blocks 510, 530, 550, and 570 can describe integrated circuitry, which can be placed or inserted into a physical layout design describing an integrated circuit device. After placement of the target blocks 510, 530, 550, and 570 into the physical layout design, the physical layout design can undergo additional design modifications, such as placement of other design blocks, routing of wiring lines between the design blocks, insertion of dummy fill structures, or the like. These additional design modifications to the physical layout design can modify the target blocks 510, 530, 550, and 570 and impact the design and/or performance of the target blocks 510, 530, 550, and 570.

In Figure 5A, the target block 510-after placement in a physical layout design-can be modified to alter the locations of the circuit structures. In this example, one of the structures in the target block 510 was moved, shown as a modified target block 522 in a higher design cell 520 of the physical layout design.

In Figure 5B, the target block 530-after placement in a physical layout design-can be modified through the insertion of dummy fill structures 544, shown as a modified target block 542 in a higher design cell 540 of the physical layout design. The dummy fill structures may be electrically-isolated fill material that can be added to the physical layout design to render the structural density of an area of an integrated circuit substantially uniform to avoid creating uneven layers during manufacturing, such layer unevenness can lead to CMP defects during a chemical mechanical polishing process In this example, the dummy fill structures 544 are included in the modified target block 542 and outside of the modified target block 542, but within the higher design cell 540.

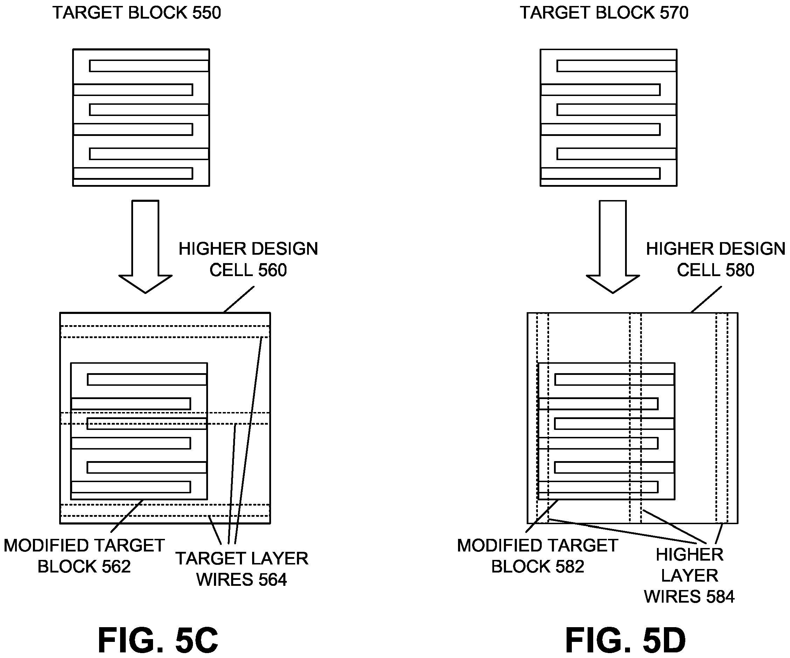

In Figure 5C, the target block 550-after placement in a physical layout design-can be modified to include wires routed within the layers of the integrated circuit having the target block 550. In this example, a higher design cell 560 of the physical layout design includes a modified target block 562 corresponding to the target block 550 and target layer wires 564 traversing the layers of the integrated circuit having the modified target block 562.

In Figure 5D, the target block 570-after placement in a physical layout design-can be modified to include wires routed at a higher level of the integrated circuit than the layers of the target block 570. In this example, a higher design cell 580 of the physical layout design includes a modified target block 582 corresponding to the target block 570 and higher layer wires 584 traversing the layers of the integrated circuit above those that include the modified target block 582.

Referring back to Figure 3, the modification identification system 323 can utilize the comparison of the candidate cells to the target design 302 in the layout versus layout validation process to determine a similarity metric for each of the candidate cells. In some embodiments, the modification identification system 323 can identify an area evaluated in the XOR operation during the comparison and determine a ratio of that area relative to the extent of the candidate, which can correspond to the similarity metric. The modification identification system 323 can compare the similarity metric against a predetermined threshold value to determine whether each unmatched candidate cell can be considered a modified version of the target design 302 or corresponds to a design unrelated to the target design 302.

The layout validation system 300 can include a validation reporting system 330 to generate the layout design validation report 303 to identify one or more design cells or design blocks in the physical layout design 301 that correspond to the target design 302 or a modified version of the target design 302. In some embodiments, the layout design validation report 303 can identify a type of modification to the target design 302 included in the physical layout design 302. For example, when the layout validation system 300 performs a validation process in a cell-only mode and in a higher-level mode, the layout validation system 300 can determine whether the modification of the target design 302 in the physical layout design 301 was within the levels of the target design 302 or in a higher-level of the physical layout design 301. The layout design validation report 303 can include the level of the modification, e.g., in the levels of the target design 302 or in a higher-level of the physical layout design 301, within the layout design validation report 303.

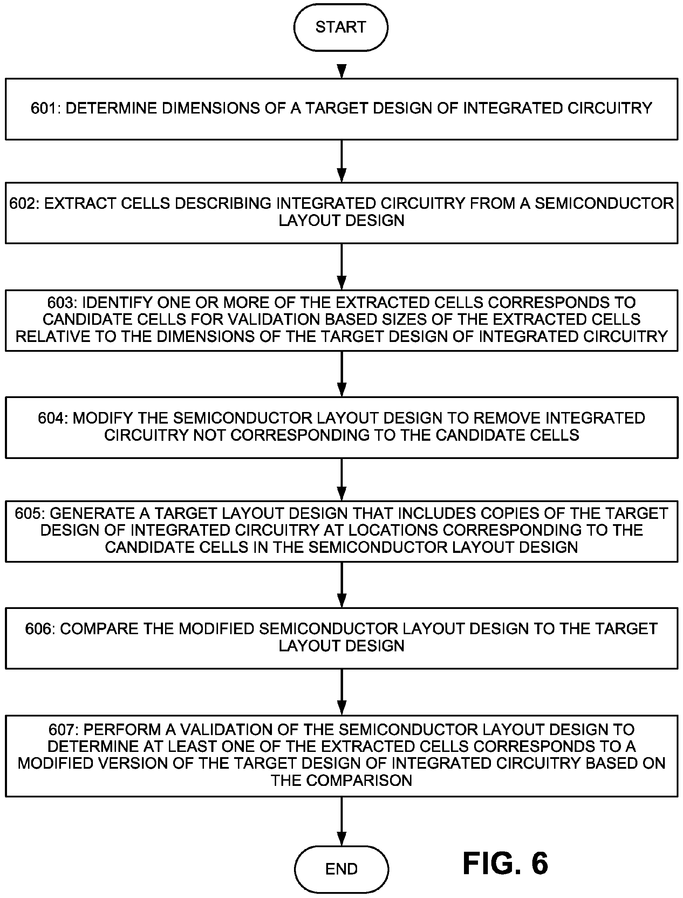

Figure 6 illustrates an example flowchart for circuit block validation and identification of circuit block modification that may be implemented according to various embodiments. Referring to Figure 6, in a block 601, a computing system implementing a layout validation system can determine dimensions of a target design of integrated circuitry. The target design can describe a block or cell of integrated circuitry as geometric information defining the shapes, such as polygon structures, capable of being created in various materials to manufacture the integrated circuit. The target design can be a previously-created design block or design cell, for example, a standard cell included in a standard cell library, a design block or design cell of design Intellectual Property (IP), for example, acquired from a third party vendor, or the like. The target design can be specified in a Graphic Data System II (GDSII) format, an Open Access format, a Milkyway format, an EDDM format, an Open Artwork System Interchange Standard (OASIS) format, or the like. The layout validation system can determine dimensions of the target design of integrated circuitry by measuring the height and width of an extent of the integrated circuitry in the target design.

The computing system implementing the layout validation system, in a block 602, can extract cells describing integrated circuitry from a semiconductor layout design. The semiconductor layout design can describe an integrated circuit as geometric information defining the shapes, such as polygon structures, capable of being created in various materials to manufacture the integrated circuit. The semiconductor layout design can be specified in a Graphic Data System II (GDSII) format, an Open Access format, a Milkyway format, an EDDM format, an Open Artwork System Interchange Standard (OASIS) format, or the like. In some embodiments, the layout validation system can extract the cells from the semiconductor layout design by identifying locations of the cells in the semiconductor layout design and determining a bounding box around the extent of the extracted cells in the semiconductor layout design.

The computing system implementing the layout validation system, in a block 603, can identify one or more of the extracted cells corresponds to candidate cells for validation based on sizes of the extracted cells relative to the dimensions of the target design of integrated circuitry. In some embodiments, the layout validation system can compare the size of the bounding box of the extracted cells to the dimensions of the target design to determine which of the extracted cells correspond to candidate cells for validation. The candidate cells can correspond to those extracted cells having a same size and/or dimensions as the target design.

The layout validation system can perform a validation to determine whether the target design matches any of the candidate cells, which would indicate an unmodified version of the target design was located in the semiconductor layout design. In some embodiments, the layout validation system can perform a comparison of the target design to the candidate cells, for example, by generating checksums of the target design and the candidate cells and then comparing the checksums of the candidate cells to the checksum of the target design. When the checksum of the target design matches a checksum of a candidate cell, the layout validation system can deem the matching candidate cell as an unmodified version of the target design placed in the semiconductor layout design.

The computing system implementing the layout validation system, in a block 604, can modify the semiconductor layout design to remove integrated circuitry not corresponding to the candidate cells. The resulting modified semiconductor layout design include the identified candidate cells without other integrated circuitry in the original semiconductor layout design. In some embodiments, the modified semiconductor layout design may also remove any candidate cells that the validation system previously deemed to correspond to an unmodified version of the target design, for example, through the above-referenced checksum matching procedure.

The computing system implementing the layout validation system, in a block 605, can generate a target layout design that includes copies of the target design of integrated circuitry at locations corresponding to the candidate cells in the semiconductor layout design. The layout validation system can generate the target layout design by identifying locations of the candidate cells in the modified semiconductor layout design and placing copies of the target design into the target layout design at the identified locations of the candidate cells in the modified semiconductor layout design.

The computing system implementing the layout validation system, in a block 606, can compare the modified semiconductor layout design to the target layout design. In some embodiments, the comparison of the modified semiconductor layout design to the target layout design can be a layer-by-layer exclusive OR (XOR) comparison of the target cells in the target layout design to the candidate cells in the modified semiconductor layout design. The comparison of the modified semiconductor layout design to the target layout design can be performed over an area corresponding to the extents of the target cells and the candidate cells. In some embodiments, the comparison of the modified semiconductor layout design to the target layout design can be performed over differing levels within the hierarchy for the semiconductor layout design, for example, within the levels of the hierarchy corresponding to the target design and candidate cells or within higher levels of the hierarchy in the semiconductor layout design.

The computing system implementing the layout validation system, in a block 607, can perform a validation of the semiconductor layout design to determine at least one of the extracted cells corresponds to a modified version of the target design of integrated circuitry based on the comparison. The layout validation system can utilize the comparison of the target layout design to the modified semiconductor layout design to determine when a candidate cell in the modified semiconductor layout design corresponds to an exact match to the target design and, when no exact match has been determined, calculate a similarity metric between the candidate cells and the target design. For example, the similarity metric can correspond to a ratio of an area used in the comparison and the area of the extent of the candidate cell. The layout validation system can utilize the similarity metric to identify whether a candidate cell corresponds to a modified version of the target design placed in the semiconductor layout design or does not correspond to the target design.

The system and apparatus described above may use dedicated processor systems, micro controllers, programmable logic devices, microprocessors, or any combination thereof, to perform some or all of the operations described herein. Some of the operations described above may be implemented in software and other operations may be implemented in hardware. Any of the operations, processes, and/or methods described herein may be performed by an apparatus, a device, and/or a system substantially similar to those as described herein and with reference to the illustrated figures.

The processing device may execute instructions or "code" stored in memory. The memory may store data as well. The processing device may include, but may not be limited to, an analog processor, a digital processor, a microprocessor, a multi-core processor, a processor array, a network processor, or the like. The processing device may be part of an integrated control system or system manager, or may be provided as a portable electronic device configured to interface with a networked system either locally or remotely via wireless transmission.

The processor memory may be integrated together with the processing device, for example RAM or FLASH memory disposed within an integrated circuit microprocessor or the like. In other examples, the memory may comprise an independent device, such as an external disk drive, a storage array, a portable FLASH key fob, or the like. The memory and processing device may be operatively coupled together, or in communication with each other, for example by an I/O port, a network connection, or the like, and the processing device may read a file stored on the memory. Associated memory may be "read only" by design (ROM) by virtue of permission settings, or not. Other examples of memory may include, but may not be limited to, WORM, EPROM, EEPROM, FLASH, or the like, which may be implemented in solid state semiconductor devices. Other memories may comprise moving parts, such as a known rotating disk drive. All such memories may be "machine-readable" and may be readable by a processing device.

Operating instructions or commands may be implemented or embodied in tangible forms of stored computer software (also known as "computer program" or "code"). Programs, or code, may be stored in a digital memory and may be read by the processing device. "Computer-readable storage medium" (or alternatively, "machine-readable storage medium") may include all of the foregoing types of memory, as well as new technologies of the future, as long as the memory may be capable of storing digital information in the nature of a computer program or other data, at least temporarily, and as long at the stored information may be "read" by an appropriate processing device. The term "computer-readable" may not be limited to the historical usage of "computer" to imply a complete mainframe, mini-computer, desktop or even laptop computer. Rather, "computer-readable" may comprise storage medium that may be readable by a processor, a processing device, or any computing system. Such media may be any available media that may be locally and/or remotely accessible by a computer or a processor, and may include volatile and non-volatile media, and removable and non-removable media, or any combination thereof.

A program stored in a computer-readable storage medium may comprise a computer program product. For example, a storage medium may be used as a convenient means to store or transport a computer program. For the sake of convenience, the operations may be described as various interconnected or coupled functional blocks or diagrams. However, there may be cases where these functional blocks or diagrams may be equivalently aggregated into a single logic device, program or operation with unclear boundaries.

### Conclusion

While the application describes specific examples of carrying out embodiments of the invention, those skilled in the art will appreciate that there are numerous variations and permutations of the above described systems and techniques that fall within the spirit and scope of the invention as set forth in the appended claims. For example, while specific terminology has been employed above to refer to design processes, it should be appreciated that various examples of the invention may be implemented using any desired combination of electronic design automation processes.

One of skill in the art will also recognize that the concepts taught herein can be tailored to a particular application in many other ways. In particular, those skilled in the art will recognize that the illustrated examples are but one of many alternative implementations that will become apparent upon reading this disclosure.

Although the specification may refer to "an", "one", "another", or "some" example(s) in several locations, this does not necessarily mean that each such reference is to the same example(s), or that the feature only applies to a single example.

## Claims

1. A method comprising:
extracting, by a computing system, cells describing integrated circuitry from a semiconductor layout design;
identifying, by the computing system, one or more of the extracted cells corresponds to candidate cells for validation based, at least in part, on sizes of the extracted cells relative to a size of a target design of integrated circuitry;
modifying, by the computing system, the semiconductor layout design to remove integrated circuitry not corresponding to the candidate cells;
generating, by the computing system, a target layout design that includes copies of the target design of integrated circuitry at locations corresponding to the candidate cells in the semiconductor layout design; and
performing, by the computing system, a validation of the semiconductor layout design by determining at least one of the extracted cells corresponds to a modified version of the target design of integrated circuitry based on a comparison of the modified semiconductor layout design and the target layout design.

2. The method of claim 1, further comprising determining, by the computing system, a bounding box for each of the extracted cells, wherein the dimensions of the bounding boxes correspond to the sizes of the extracted cells.

3. The method of claim 1 or 2, further comprising comparing, by the computing system, the modified semiconductor layout design and the target layout design on a layer-by-layer basis.

4. The method of claim 3, wherein comparing the modified semiconductor layout design and the target layout design is performed on at least one of levels of the semiconductor layers including integrated circuitry corresponding to the extracted cells or all levels of the semiconductor layers.

5. The method of claim 4, wherein comparing the modified semiconductor layout design and the target layout design further comprises performing am exclusive OR (XOR) logic operation on candidate cells in the modified semiconductor layout design and the target design of integrated circuitry in the target layout design.

6. The method of any one of claims 1-5, wherein the modified version of the target design of integrated circuitry includes at least one of a modification to the integrated circuitry in the target design, additional dummy fill structures in the extent of the target design of integrated circuitry, wire routing in the semiconductor layer corresponding to the extracted cells, or wire routing in a higher semiconductor layer than the extracted cell.

7. The method of any one of claims 1-6, wherein performing the validation of the semiconductor layout design further comprises determining a similarity percentage corresponding to a degree of difference between the candidate design and the target design of integrated circuitry.

8. The method of claim 7, wherein performing the validation of the semiconductor layout design further comprises comparing the similarity percentage to a threshold value to determine at least one of the extracted cells corresponds to the modified version of the target design of integrated circuitry.

9. A system comprising:
a memory system configured to store computer-executable instructions; and
a computing system, in response to execution of the computer-executable instructions, is configured to carry out the steps according to the method of any one of claims 1-8.

10. An apparatus comprising at least one computer-readable memory device storing instructions configured to cause one or more processing devices to perform operations comprising the steps according to the method of any one of claims 1-8.

11. A computer program product comprising instructions which, when the program is executed by a computer, cause the computer to carry out the steps of the method of any one of claims 1-8.

12. A computer-readable data carrier having stored thereon the computer program product of claim 11.
